(19) **Europäisches Patentamt / European Patent Office / Office européen des brevets**

(11) **EP 3 544 061 A1**

(12) # EUROPEAN PATENT APPLICATION
published in accordance with Art. 153(4) EPC

(43) Date of publication:
**25.09.2019 Bulletin 2019/39**

(51) Int Cl.:
***H01L 31/05*** (2014.01)

(21) Application number: **17885027.7**

(22) Date of filing: **12.12.2017**

(86) International application number:
**PCT/JP2017/044497**

(87) International publication number:
**WO 2018/116899 (28.06.2018 Gazette 2018/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **22.12.2016  JP 2016249506**

(71) Applicant: **Panasonic Intellectual Property Management Co., Ltd.**
**Osaka-shi, Osaka 540-6207 (JP)**

(72) Inventors:
  • **TAIRA, Shigeharu**
    **Osaka-shi, Osaka 540-6207 (JP)**
  • **HITACHI, Naohiro**
    **Osaka-shi, Osaka 540-6207 (JP)**
  • **SAITA, Atsushi**
    **Osaka-shi, Osaka 540-6207 (JP)**

  • **YOSHIMINE, Yukihiro**
    **Osaka-shi, Osaka 540-6207 (JP)**
  • **MORIKAWA, Ryota**
    **Osaka-shi, Osaka 540-6207 (JP)**
  • **ISHIMURA, Kenta**
    **Osaka-shi, Osaka 540-6207 (JP)**
  • **KUNII, Toshie**
    **Osaka-shi, Osaka 540-6207 (JP)**
  • **TANAKA, Kenji**
    **Osaka-shi, Osaka 540-6207 (JP)**
  • **MAEKAWA, Akimichi**
    **Osaka-shi, Osaka 540-6207 (JP)**
  • **HASHIMOTO, Haruhisa**
    **Osaka-shi, Osaka 540-6207 (JP)**
  • **IRIKAWA, Junpei**
    **Osaka-shi, Osaka 540-6207 (JP)**

(74) Representative: **Müller-Boré & Partner**
    **Patentanwälte PartG mbB**
    **Friedenheimer Brücke 21**
    **80639 München (DE)**

(54) ## SOLAR BATTERY MODULE

(57)    The solar battery module 10 according to one embodiment of the present invention is provided with: multiple solar battery cells 11; a first protective member 12; a second protective member 13; a first wiring material 15 for connecting adjacent solar cells 11; and a second wiring material 16 for connecting strings 23, that have been obtained by connecting the multiple solar cells 11 via the first wiring material 15, to each other. The first wiring material 15 and/or the second wiring material 16 has a conductive core material and a colored layer 31 that covers a surface on the side of the core material that faces the first protective member 12. The colored layer 31 absorbs at least 30% of visible light having a wavelength of 380 - 780 nm.

FIG. 1

## Description

TECHNICAL FIELD

The present invention relates to a solar battery module.

BACKGROUND

A solar battery module is provided with multiple solar cells, a first wiring material for connecting adjacent solar cells, and a second wiring material for connecting strings to each other obtained by connecting the multiple solar cells via the first wiring material (see Patent Literature 1, for example). A wiring material containing aluminum as a main component is used for the solar battery module disclosed in Patent Literature 1.

CITATION LIST

PATENT LITERATURE

Patent Literature 1: Japanese Unexamined Patent Application Publication No. 2016-143680

SUMMARY

TECHNICAL PROBLEM

However, since the color of the solar cells is largely different from the color of the wiring materials, the wiring materials are more conspicuous than the solar cells when the wiring materials are attached to the solar cells. Improving the design properties of the solar battery module by preventing the wiring material from becoming conspicuous or imparting more designability to the wiring material without degrading the performance of the solar battery module is one effective means for enhancing a commercial value.

SOLUTION TO PROBLEM

A solar battery module according to an aspect of the present disclosure includes multiple solar cells, a first protective member provided on a light receiving surface side of the multiple solar cells, a second protective member provided on a rear surface side of the multiple solar cells, a first wiring material for connecting adjacent solar cells, and a second wiring material for connecting strings, that have been obtained by connecting the multiple solar cells via the first wiring materials, to each other, wherein at least one of the first wiring material and the second wiring material has a conductive core material, and a colored layer that covers a surface on the side of the core material that faces the first protective member, and the colored layer absorbs at least 30% of visible light having wavelengths of 380 nm to 780 nm.

ADVANTAGEOUS EFFECTS OF INVENTION

It can be an advantage of one aspect of the present disclosure to provide a solar battery module that can prevent a wiring material from becoming conspicuous and provide excellent design properties while maintaining good performance. According to one aspect of the present disclosure, the solar battery module can provide good mechanical and electrical connection between the wiring materials or between the wiring material and the solar cell, for example, even when a colored layer is provided on a surface of the wiring material.

BRIEF DESCRIPTION OF DRAWINGS

FIG. 1 is a sectional view of a solar battery module as an example of embodiments.
FIG. 2A is a sectional view in a width direction of a first wiring material illustrated in FIG. 1.
FIG. 2B is a sectional view in the width direction illustrating another example of the first wiring material.
FIG. 3A is a sectional view of a connection portion between a first wiring material and a second wiring material as an example of embodiments.
FIG. 3B is a sectional view illustrating another example of a connection portion between the first wiring material and the second wiring material.

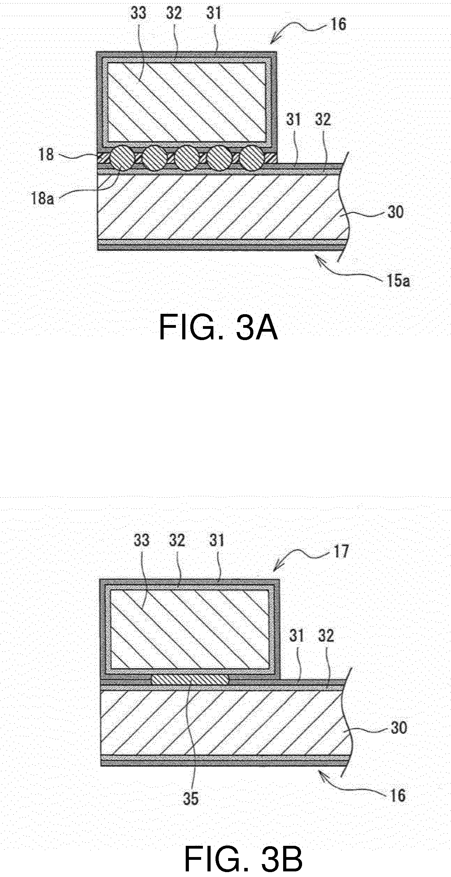

FIG. 3B is a sectional view illustrating another example of a connection portion between the first wiring material and the second wiring material.

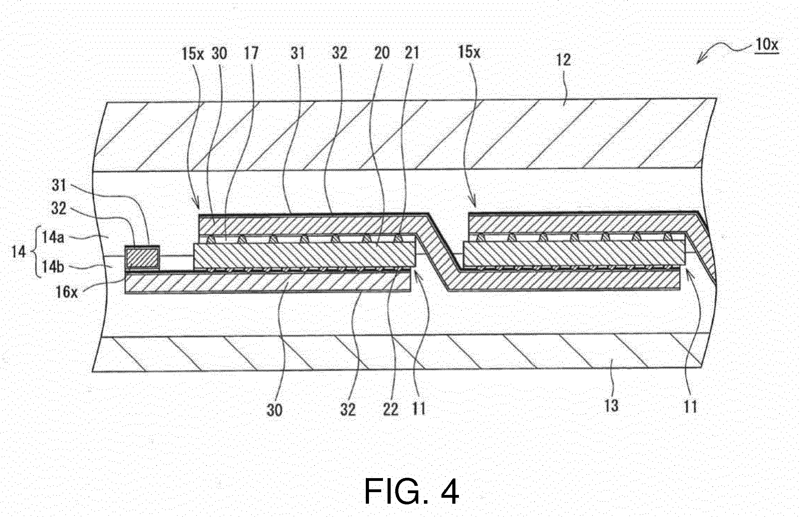

FIG. 4 is a sectional view of a solar battery module as another example of embodiments.

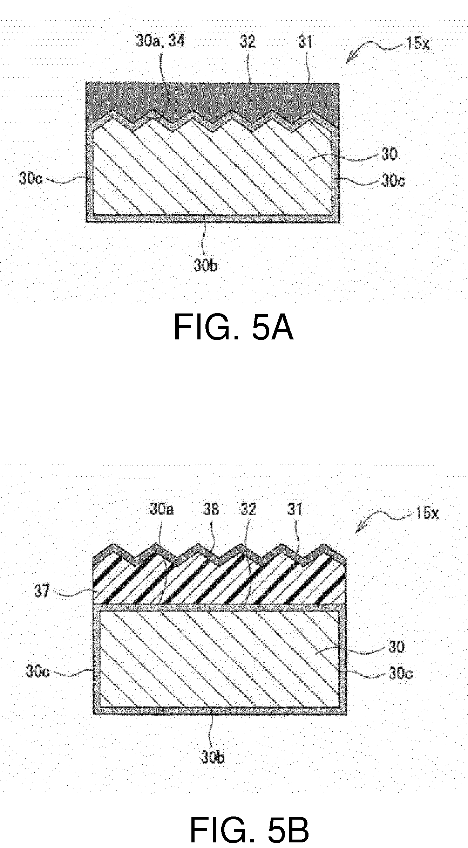

FIG. 5A is a sectional view in a width direction of a first wiring material illustrated in FIG. 4.
FIG. 5B is a sectional view in the width direction illustrating another example of the first wiring material.

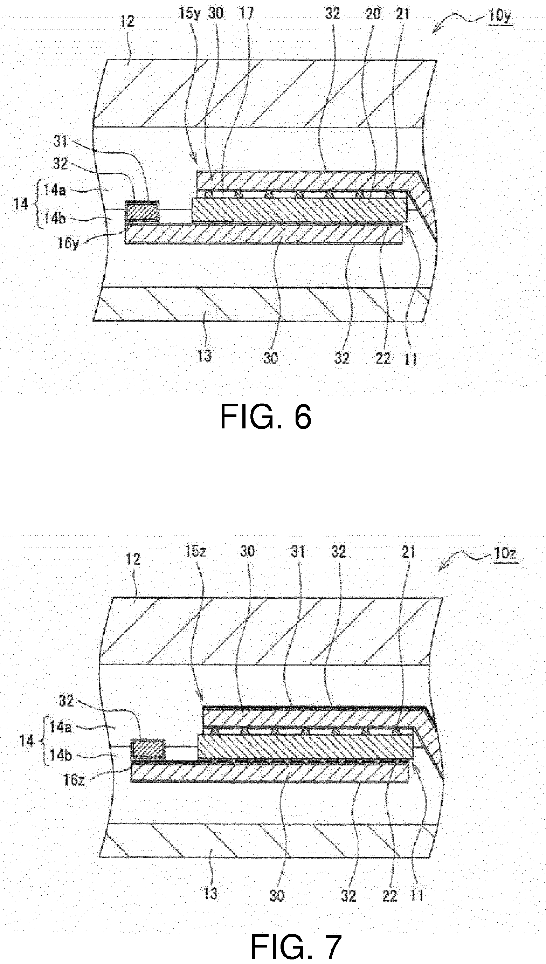

FIG. 6 is a sectional view of a solar battery module as another example of embodiments.
FIG. 7 is a sectional view of a solar battery module as another example of embodiments.

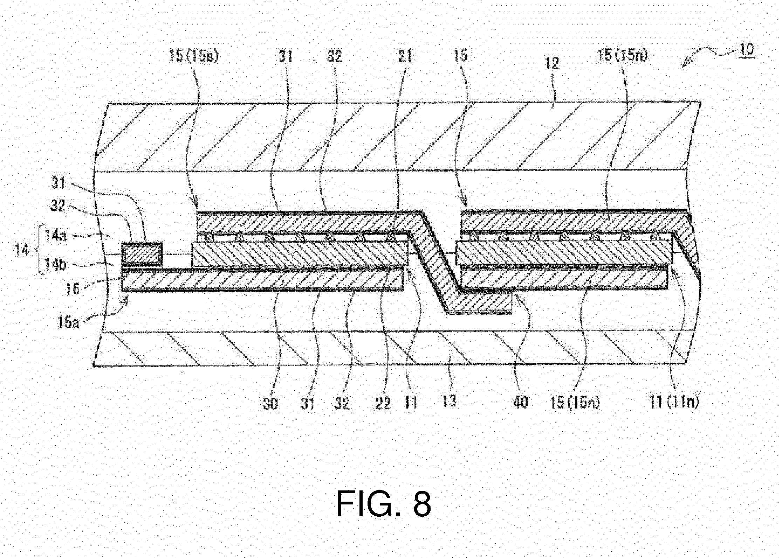

FIG. 8 is a sectional view of a solar battery module as another example of embodiments.

DESCRIPTION OF EMBODIMENTS

Hereinafter, an example of the embodiments will be described in detail with reference to the drawings. The drawings referred to in the description of the embodiments are schematically drawn, and the dimensional proportions or the like of the constituent elements depicted in the drawings are sometimes different from those of the actual constituent elements. Specific dimensional proportions or the like should be determined in consideration of the following descriptions. It is originally assumed that constituent elements of multiple embodiments described below are selectively combined.

In the present specification, regarding the expression "substantially," for example, "substantially the same" is intended to include not only exactly the same but also something that can be substantially recognized as the same. It should be noted that, unless specifically limited, an expression such as "provide a second member on a first member" is not intended only for a case in which the first and second members are provided in direct contact with each other. In other words, examples of this expression include a case in which another member is provided between the first and second members.

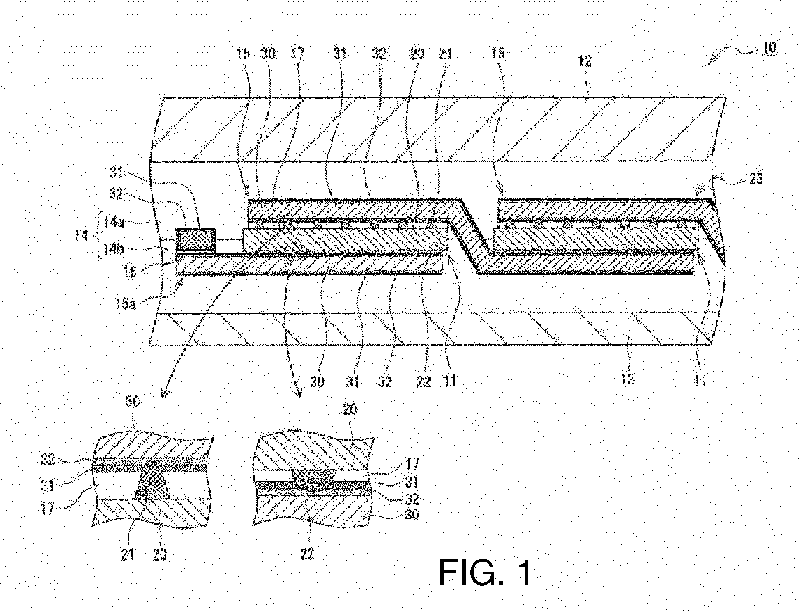

FIG. 1 is a sectional view of a solar battery module 10 as an example of embodiments. As exemplified in FIG. 1, the solar battery module 10 includes multiple solar cells 11, a first protective member 12 provided on a light receiving surface side of the multiple solar cells 11, and a second protective member 13 provided on a rear surface side of the multiple solar cells 11. The multiple solar cells 11 are interposed between the first protective member 12 and the second protective member 13, and are sealed by an encapsulant layer 14 provided between their protective members. The solar battery module 10 includes a first wiring material 15 for connecting the adjacent solar cells 11, and a second wiring material 16 for connecting strings 23, that have been obtained by connecting the multiple solar cells 11 via the first wiring materials 15, to each other.

The term "light receiving surface" of the solar cell 11 refers to a surface which light mainly enters, and the term "rear surface" refers to a surface opposite to the light receiving surface. Of light entering the solar cell 11, more than 50% to 100% of light enters the solar cell 11 through the light receiving surface, for example. The terms "light receiving surface" and "rear surface" are used for a photoelectric conversion part, and the like.

Although the detail will be described later, at least one of the first wiring material 15 and the second wiring material 16 has a conductive core material, and a colored layer 31 that covers a surface on the side of the core material that faces the first protective member 12. The colored layer 31 absorbs at least 30% of visible light having wavelengths of 380 nm to 780 nm, and exhibits black or blue black that is the same as the color of the solar cell 11, for example. In the following description, the light having wavelengths of 380 nm to 780 nm is referred to as "visible light," unless otherwise specified. The wiring material is prevented from becoming conspicuous by providing the colored layer 31 that absorbs at least 30% of visible light, or greater designability of the solar battery module is imparted to the wiring material, thereby enabling the design properties of the solar battery module 10 to be improved.

In the solar battery module 10, the multiple solar cells 11 are arranged on substantially the same plane. The solar cells 11 adjacent to each other are connected in series via the first wiring material 15. Thus, a string 23 of the solar cells 11 is formed. The first wiring material 15 is bent, between the adjacent solar cells 11, in the thickness direction of the module, and is attached to the light receiving surface of one solar cell 11 and the rear surface of the other solar cell 11 using an adhesive 17. The first wiring material 15 may be soldered to the solar cells 11. In any case, collector electrodes 21, 22 described later are electrically connected to the first wiring material 15. The first wiring material 15 is typically referred to as an interconnector, or a tab.

The solar battery module 10 has the multiple strings 23 in each of which the multiple solar cells 11 are arranged in one line. The multiple strings 23 each include the same number of solar cells 11, and are arranged substantially parallel to one another. Multiple second wiring materials 16 are provided on both sides in a longitudinal direction of each string 23, so as to be substantially perpendicular to the longitudinal direction. The second wiring material 16 is connected to a first wiring material 15a extending from the solar cell 11 positioned on both sides of each string 23. The first wiring material 15a is different from the other first wiring material 15 in that the first wiring material 15a connects one solar cell 11 and the second wiring material 16. Furthermore, the length of the first wiring material 15a is shorter than that of the other first wiring material 15 for connecting the solar cells 11 that are adjacent to each other. In the following description, the first wiring materials 15 include the first wiring material 15a, unless otherwise specified.

The multiple strings 23 are connected in series via the second wiring materials 16. The second wiring material 16 is typically referred to as a bridging tab. The solar battery module 10 may be provided with a terminal box (not illustrated) in which a bypass diode is built, on a rear side of the second protective member 13, so that a part of the second wiring material 16 extends into the terminal box directly or through the other conductive member. When a part of the solar cell 11 is shaded, for example, the string 23 containing the shaded solar cell 11 is bypassed by the bypass diode. An output cable is connected to the terminal box.

The multiple solar cells 11 each include a photoelectric conversion part 20, and collector electrodes provided on the photoelectric conversion part 20. In the present embodiment, a collector electrode 21 being a light receiving surface electrode formed on the light receiving surface of the photoelectric conversion part 20 and a collector electrode 22 being a rear surface electrode formed on the rear surface of the photoelectric conversion part 20 are provided as collector electrodes for collecting carriers. The height of the collector electrode 22 is smaller than the collector electrode 21, for example, and is formed in a larger area than the collector electrode 21. The height of the collector electrode 21 is about 5 $\mu$m to 50 $\mu$m, and the height of the collector electrode 22 is about 3 $\mu$m to 30 $\mu$m. The number of finger electrodes, described later, of the collector electrode 22 is typically larger than that of the collector electrode 21. Although the detail will be described later, the collector electrodes 21, 22 are connected to the first wiring material 15 while penetrating the colored layer 31 of the first wiring material 15.

The photoelectric conversion part 20 has a function of producing carriers upon receiving solar light. The photoelectric conversion part 20 includes a semiconductor substrate made of, for example, crystalline silicon (Si), gallium arsenide (GaAs), indium phosphide (InP), or the like, an amorphous semiconductor layer formed on the semiconductor substrate, and a transparent conductive layer formed on the amorphous semiconductor layer. As a specific example, a structure may be employed in which an i-type amorphous silicon layer, a p-type amorphous silicon layer, and a transparent conductive layer are sequentially formed on one surface of an n-type monocrystalline silicon substrate, and an i-type amorphous silicon layer, an n-type amorphous silicon layer, and a transparent conductive layer are sequentially formed on the other surface. The transparent conductive layer is formed from a transparent conductive oxide in which a metal oxide such as indium oxide ($In_2O_3$) and zinc oxide (ZnO) is doped with tin (Sn), antimony (Sb), or the like. The photoelectric conversion part 20 has a substantially square shape in a plan view formed by obliquely cutting four corners thereof, for example.

Each of the collector electrodes 21, 22 preferably includes the multiple finger electrodes. Note that the collector electrode 22 may be an electrode covering substantially the entire region of the rear surface of the photoelectric conversion part 20. The multiple finger electrodes are thin linear electrodes formed to be substantially parallel to one another. Each of the collector electrodes 21, 22 may include a bus bar electrode having a width larger than the width of the finger electrode, the bus bar electrode being substantially perpendicular to each of the finger electrodes. When the bus bar electrode is provided, the first wiring material 15 is attached along the bus bar electrode. The first wiring material 15 may have a width larger than the width of the bus bar electrode. In this case, the first wiring material 15 protrudes from the bus bar electrode, and both end portions in the width direction of the first wiring material 15 are positioned on the corresponding finger electrodes. The collector electrodes 21, 22 illustrated in FIG. 1 are the finger electrodes.

Each of the collector electrodes 21, 22 is, for example, formed of a conductive filler and a binder which binds the filler. Examples of the conductive filler include metal particles such as silver (Ag), copper (Cu), and nickel (Ni), or carbon, or a mixture thereof. Examples of the binders include curable resin obtained by adding, as needed, a curing agent to epoxy resin, silicon resin, urethane resin, or the like, a glass frit, and the like. Of these, Ag particles and epoxy resin are particularly preferably used as the conductive filler and the binder, respectively. For example, the collector electrodes 21, 22 are formed by screen printing a conductive paste. Note that the collector electrodes 21, 22 are not limited to electrodes using the conductive paste, and may be metal electrodes formed by plating.

For the first protective member 12, a member having transparency such as a glass substrate, a resin substrate, a resin film, or the like may be used, for example. For the first protective member 12, a glass substrate is preferably used from the viewpoint of heat resistance and endurance. The thickness of the glass substrate is, for example about 0.5 mm to 6 mm.

For the second protective member 13, the same transparent member as the first protective member 12 may be used or a non-transparent member may be used. In the present embodiment, for the second protective member 13, a resin film is used. The resin film is not limited to a particular resin film, but preferable examples of the resin film include a polyethylene terephthalate (PET) film. The thickness of the resin film is, for example, about 50 to 300 $\mu$m.

The second protective member 13 preferably has a similar color to the color of the solar cell 11. Since the solar cell 11 is black or blue black in color, the color of the second protective member 13 is, for example, black or blue black in color. When the solar cell 11 has a similar color to the color of the second protective member 13, the second protective member 13 that is visible from a gap between solar cells can be prevented from becoming conspicuous when the solar battery module 10 is viewed from the light receiving surface side (the first protective member 12 side), thereby improving the design properties of the module.

The second protective member 13 preferably absorbs at least 30% of visible light, and may have the same light absorptivity as the light absorptivity of the colored layer 31 of the wiring material. The second protective member 13 has a structure in which a coloring material absorbing visible light is dispersed inside the resin forming the resin film. Alternatively, the second protective member 13 may have a structure in which multiple resin layers are laminated, and at least one layer of the resin layers may contain a coloring material. For the coloring material, the same coloring material as the coloring material contained in the colored layer 31 may be used. The second protective member 13 and the colored layer may contain the same type of coloring material. A similar layer to the colored layer 31 may be formed on the surface of the resin film by printing or the like, so that the second protective member 13 is colored.

The encapsulant layer 14 includes a first encapsulant layer 14a provided between the solar cells 11 and the first protective member 12, and a second encapsulant layer 14b provided between the solar cells 11 and the second protective member 13. Examples of the resins forming the encapsulant layer 14 include polyolefin, polyester, epoxy resin, and a copolymer of $\alpha$ olefin, and carboxylic acid vinyl, or the like. Preferable are the polyolefin, and the copolymer of $\alpha$ olefin and carboxylic acid vinyl (ethylene vinyl acetate copolymer).

The first encapsulant layer 14a and the second encapsulant layer 14b may be made of the same material or different materials. When the first encapsulant layer 14a and the second encapsulant layer 14b are made of the same material, a boundary between these layers is not clearly defined in some cases. For example, the second encapsulant layer 14b may contain the coloring material, but in the present embodiment, the second encapsulant layer 14b is made of a colorless transparent resin.

The first wiring material 15 and the second wiring material 16 are each a wiring material having a rectangular shape, and have conductive core materials 30, 33, respectively. Since the thickness of the colored layer 31 or the like is thin, the dimensions (width, length, and thickness) of the respective wiring materials depend on the dimensions of the core materials 30, 33. The dimensions of the core materials 30, 33 are not limited to particular dimensions, but the width of the core material 33 of the second wiring material 16 is typically larger than the width of the core material 30 of the first wiring material 15. The core materials 30, 33 are typically made of copper or copper alloy. Note that the core materials 30, 33 may be made of another metal such as aluminum or nickel, as a main component.

In the present embodiment, each of the first wiring material 15 and the second wiring material 16 is provided with the colored layer 31. The thickness of the colored layer 31 of the first wiring material 15 is different depending on each type of the colored layer 31, but is, for example, 0.5 $\mu$m to 40 $\mu$m, and an example of a preferable range of the thickness of the colored layer 31 is 1 $\mu$m to 20 $\mu$m. The thickness of the colored layer 31 of the second wiring material 16 may be larger than the thickness of the colored layer 31 of the first wiring material 15, and is, for example, 100 $\mu$m or less, and preferably 50 $\mu$m or less. The colored layer 31 has a similar color to the solar cell 11, thereby preventing each wiring material from becoming conspicuous. Since the solar cell 11 is black or blue black in color, the colored layer 31 is preferably black or blue black in color.

As described above, since the second protective member 13 preferably has a similar color to the solar cells 11, the solar cells 11, the second protective member 13, and each wiring material preferably have similar colors when the solar battery module 10 is viewed from the first protective member 12 side. Furthermore, not only hue but also the color tones such as lightness and chroma saturation of the solar cells 11, the second protective member 13, and each wiring material are preferably adjusted to be about the same level.

The first wiring material 15 preferably includes a base layer 32 provided between the core material 30 and the colored layer 31. Providing the base layer 32 enables various functions to be imparted to the first wiring material 15. A difference between coefficients in linear thermal expansion of the solar cell 11 and the first wiring material 15 is assumed to cause curling and cracks of the cell and separation of the first wiring material 15, but providing the base layer 32 enables the flexibility of the first wiring material 15 to be improved, for example, thereby improving such problems. The base layer 32 may have a multi-layer structure, and the physical properties such as hardness and coefficients in linear thermal expansion of the colored layer 31 and the layer formed on a surface of the core material 30 may be gradually changed.

An Ag plating layer and an Ni plating layer may be provided as the base layer 32. When the core material 30 is made of copper as a main component, for example, copper may disperse into the encapsulant layer 14, to thereby cause yellowing of the encapsulant layer 14, decrease in molecular weight and the like. However, when the Ag plating layer and the Ni plating layer are provided as the base layer 32, the problems caused by dispersion of copper can be suppressed. The thickness of each of the Ag plating layer and the Ni plating layer is, for example, 0.5 $\mu$m to 10 $\mu$m.

A layer of low melting point alloy such as an Sn-Ag-Cu alloy, an Sn-Cu-Ni alloy, a Zn-Cu-Ni alloy, an Sn-Ag-Cu alloy, an Sn-Pb alloy, and an Sn-Pb-Ag alloy may be provided as the base layer 32, the low melting point alloy being used for soldering. In particular, when the first wiring material 15 is soldered to the collector electrodes 21, 22, the layer of low melting point alloy is preferably provided. The layer of low melting point alloy can be formed by a molten solder plating method. The thickness of the layer of low melting point alloy is, for example, 1 $\mu$m to 40 $\mu$m.

The second wiring material 16 also preferably includes a base layer 32. The base layer 32 provided in the second wiring material 16 may be the same as or different from that provided in the first wiring material 15. For example, the Ag plating layer may be provided as the base layer 32 of the first wiring material 15, and the layer of low melting point alloy may be provided as the base layer 32 of the second wiring material 16.

In the structure illustrated in FIG. 1, the collector electrodes 21, 22 of the solar cell 11 are formed so that the heights of the collector electrodes 21, 22 are larger than the thicknesses of the colored layers 31 of the first wiring materials 15, respectively, and the collector electrodes 21, 22 are connected to the first wiring materials 15 in a state where the collector electrodes 21, 22 penetrate the respective colored layers 31 of the first wiring materials 15. The collector electrodes 21, 22 that have penetrated the respective colored layers 31 pierce into the respective base layers 32. When the conductivity of the colored layer 31 is low, or when the colored layer 31 is an insulator that does not have conductivity, each of the collector electrodes 21, 22 is preferably in direct contact with the corresponding base layer 32 or core material 30 through the corresponding colored layer 31 of the first wiring material 15. For example, when base layers 32 that are softer than and thicker than the colored layers 31 are provided, the collector electrodes 21, 22 can easily penetrate the respective colored layers 31 when the first wiring materials 15 are attached to the solar cell 11 by being pressed against the collector electrodes 21, 22, respectively.

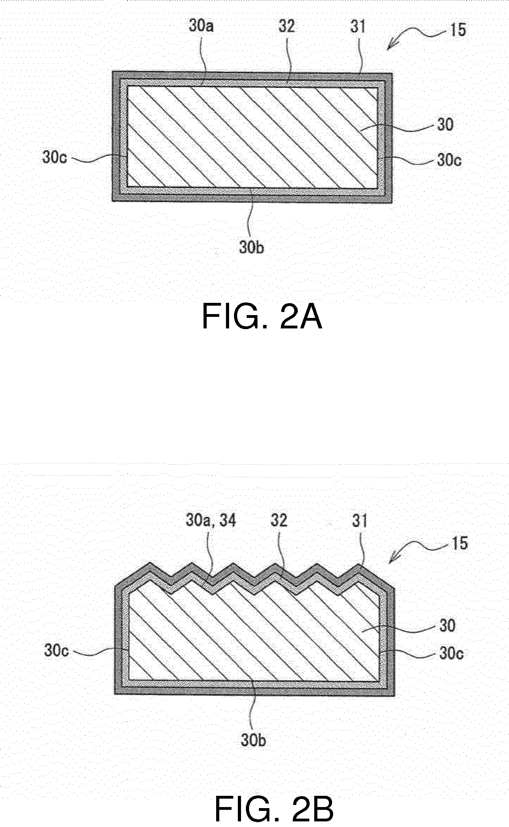

FIGs. 2A and 2B are each a sectional view in a width direction of the first wiring material 15. As illustrated in FIG. 2A, the colored layer 31 is formed by a first surface 30a of the core material 30 of the first wiring material 15, the first surface 30a facing the first protective member 12 side, a second surface 30b of the core material 30, the second surface 30b facing the second protective member 13 side, and side surfaces 30c along the longitudinal direction of the core material 30. The colored layer 31 is formed by the first surface 30a, the second surface 30b, and the side surfaces 30c, to form the first wiring material 15 having a symmetrical layer structure, thereby making curling less likely to occur to improve the reliability.

The colored layer 31 is formed over the entire surface of the core material 30 except for both end surfaces in the longitudinal direction of the core material 30. The first wiring material 15 is obtained by forming the colored layer 31 on an elongated body of the core material 30 by a method such as plating or coating the elongated body, for example, and then cutting the elongated body. In this case, the colored layer 31 is not formed on both end surfaces in the longitudinal direction of the core material 30. Note that after the elongated body is cut, the colored layer 31 may be formed on both end surfaces in the longitudinal direction of the core material 30.

In an example illustrated in FIG. 2A, the base layer 32 is formed over the entire surface of the core material 30 except for both end surfaces in the longitudinal direction of the core material 30, in the same manner as the colored layer 31. That is, the base layer 32 is necessarily interposed between the core material 30 and the colored layer 31. In the present embodiment, also in the second wiring material 16, the colored layer 31 and the base layer 32 are formed on the entire surface of the core material 33 except for both end surfaces in the longitudinal direction of the core material 33 (see FIG. 1, and FIG. 3A and the like described later).

In an example illustrated in FIG. 2B, protrusions and recesses 34 are formed on the first surface 30a of the core material 30. In the protrusions and recesses 34, the protrusions each having a substantially triangular shape in cross section are regularly formed in the width direction of the core material 30. The recess having a substantially V shape is formed between adjacent protrusions. The protrusions and recesses 34 are formed along the longitudinal direction of the core material 30, for example. When the protrusions and recesses 34 are formed on the first surface 30a, the light which has struck the first surface 30a can be diffused to increase an amount of the light incident on the solar cell 11. The light which has struck the first wiring material 15 is absorbed by the colored layer 31, for example, but some of the light that has passed through the colored layer 31 is reflected by the surface of the base layer 32 or the surface of the core material 30, and is reflected by the first protective member 12 and the like again, to thereafter enter the solar cell 11.

In the example illustrated in FIG. 2B, the colored layer 31 and the base layer 32 are formed along the protrusions and recesses 34 of the first surface 30a. That is, the protrusions and recesses 34 are also reflected in the colored layer 31 forming the outermost surface of the first wiring material 15. On the surface of the core material 30, fine protrusions and recesses may be formed to reflect incident light irregularly, instead of regular protrusions and recesses 34, and the surface of the core material 30 and the surface of the base layer 32 may be matted to have suitable surface roughness. The surface roughness of the colored layer 31 may be larger than the surface roughness of the core material 30.

FIGs. 3A to 3C are each a sectional view of a connection portion between the first wiring material 15a and the second wiring material 16. As illustrated in FIGs. 3A to 3C, the colored layer 31 is necessarily interposed between the first wiring material 15a and the second wiring material 16. Note that in FIGs. 3A to 3C, the colored layer 31 is formed on each of the first wiring material 15a and the second wiring material 16, but in the configuration described below, the present invention can also be applied similarly to a case where the colored layer 31 is formed only on one of the wiring materials. When the colored layer 31 is not formed between the first wiring material 15a and the second wiring material 16, the wiring materials may be connected by typical soldering or the like, in a conventional manner.

In an example illustrated in FIG. 3A, the first wiring material 15a and the second wiring material 16 are connected using an adhesive 18 containing conductive fillers 18a. The conductive fillers 18a may penetrate the colored layers 31 of the respective wiring materials to pierce into the base layers 32 of the respective wiring materials. When the conductivity of the colored layer 31 is low, or when the colored layer 31 is an insulator that does not have conductivity, each of the conductive fillers 18a is preferably in direct contact with the base layers 32 or the core materials 30, 33 through the colored layers 31.

The conductive fillers 18a each having a particle size greater than or equal to the thickness of the colored layer 31 may exist between the first wiring material 15a and the second wiring material 16, so that one conductive filler 18a contacts the base layers 32 of the respective wiring materials. A conductive path may be formed between the wiring materials through the multiple conductive fillers 18a.

In an example illustrated in FIG. 3B, the first wiring material 15a and the second wiring material 16 are connected through a conductive member 35. The conductive member 35 may be metals contained in the base layer 32 or the core materials 30, 33 or may be another conductive member. In any case, the conductive member 35 is preferably provided to penetrate the colored layers 31 to be in direct contact with the base layers 32 of the respective wiring materials or the core materials 30, 33.

For example, when a layer of low melting point alloy is provided as the base layer 32, and the first wiring material 15a and the second wiring material 16 are connected by soldering or welding, the colored layers 31 may be melted or decomposed by heat at the time of joining to form a hole, so that the base layers 32 melted through the hole are joined to each other. Alternatively, after the colored layers 31 are removed, a joining portion between the first wiring material 15a and the second wiring material 16 may be formed by soldering, welding, bonding using a conductive adhesive, or the like.

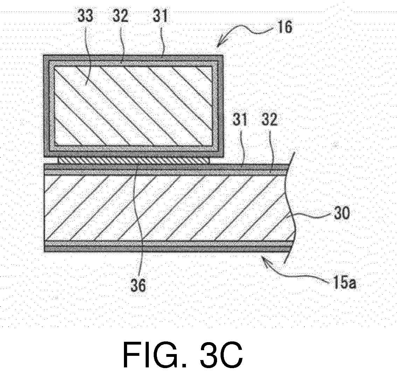

In the examples illustrated in FIGs. 3A and 3B, the first wiring material 15a and the second wiring material 16 are connected through a conductive member which penetrates the colored layers 31. In contrast, in an example illustrated in FIG. 3C, the colored layers 31 of the respective wiring materials are joined through a conductive member 36. When the conductivity of the colored layer 31 is high, such a joint configuration may be adopted. For example, a low melting point alloy, a conductive adhesive or the like may be used for the conductive member 36.

When the first wiring material 15a and the second wiring material 16 are connected by soldering, the type of the base layer 32 in a surface of the second wiring material 16 that faces the first wiring material 15a side may be different from the type of the base layer 32 in the surface of the second wiring material 16 that is opposite to the first wiring material 15a side, to prevent the colored layers 31 from collapsing due to solder melting. For example, the base layer 32 in the surface of the core material 33 that faces the first wiring material 15a side may be formed of a low melting point alloy, and the base layer 32 in the surface opposite thereto may be formed of a high melting point alloy. Alternatively, the solder plating is conducted after the colored layer 31 is formed on one surface of the second wiring material 16 (core material 33) using a material that repels solder plating, such that the outermost layer of the one surface of the second wiring material 16 may be the colored layer 31, and the outermost layer of the other surface may become a low melting point alloy layer. In this case, the low melting point alloy layer faces the first wiring material 15a side, and is soldered. The first wiring material 15a and the second wiring material 16 may be soldered to each other in a state where a solder connecting portion is not in contact with the surface of a support plate because the colored layer 31 easily collapses when the solder connection is conducted on the support plate. For example, the support plate in which a through hole or a recess is formed may be used to solder in a state where the solder connecting portion is positioned on the through hole or the recess.

FIG. 4 is a sectional view of a solar battery module 10x as another example of embodiments. As illustrated in FIG. 4, the solar battery module 10x is different from the solar battery module 10 in that the first wiring material 15x and the second wiring material 16x are provided in which the respective core materials 30, 31 each have the colored layer 31 formed only on the first surface that faces the first protective member 12 side. That is, in the solar battery module 10x, the wiring materials in which the respective core materials 30, 33 each have the colored layer 31 formed on one surface thereof are disposed so that the colored layer 31 faces the first protective member 12 side. In this case, the collector electrode 21 can be easily connected to the first wiring material 15, for example. Note that the base layer 32 may be formed over the entire surface of each of the core materials 30, 33 except for both end surfaces in the longitudinal direction of each of the core materials 30, 33, or may be formed only on each of portions between the core material 30 and the colored layer 31 and between the core material 33 and the colored layer 31.

FIGs. 5A and 5B each are a sectional view in the width direction of the first wiring material 15x. As described above, in the first wiring material 15x, the colored layer 31 is formed only on the first surface 30a of the core material 30 that faces the first protective member 12 side. In the structure illustrated in FIG. 5A, the protrusions and recesses 34 are formed on the first surface 30a of the core material 30, similarly to the structure illustrated in FIG. 2B. On the other hand, in the first wiring material 15x illustrated in FIG. 5A, the colored layer 31 having a thickness greater than the depth of the protrusions and recesses 34 is formed to be embedded in the recesses. That is, the surface of the colored layer 31 is substantially flat without having large irregularities. Also in this case, a portion of light that has passed through the colored layer 31 is reflected by the surface of the base layer 32 or the surface of the core material 30, thereby increasing an amount of the light incident on the solar cell 11.

In an example illustrated in FIG. 5B, a resin layer 37 having protrusions and recesses 38 formed on a surface thereof is provided on the flat first surface 30a of the core material 30. The colored layer 31 is formed on the surface of the resin layer 37. In the protrusions and recesses 38, the protrusions each having a substantially triangular shape in cross section are regularly formed in the width direction of the core material 30, similarly to the protrusions and recesses 34. The colored layer 31 is formed along the protrusions and recesses 38, and the protrusions and recesses 38 are also reflected in the surface of the colored layer 31.

When the first wiring material 15x illustrated in FIG. 5B is used, a portion of light that has passed through the colored layer 31 is reflected by the surface of the resin layer 37 or the like, thereby increasing an amount of the light incident on the solar cell 11. Note that the resin layer 37 is formed only on a portion of the first wiring material 15x that is positioned on the light receiving surface of the solar cell 11 so that the first wiring material 15x is easily connected to the collector electrode 22. The resin layer 37 may be used as an adhesive layer for bonding the first wiring material 15x to the rear surface of the solar cell 11, or surface unevenness may be formed using the base layer 32, instead of the resin layer 37.

FIG. 6 and FIG. 7 are sectional views illustrating solar battery modules 10y, 10z as other embodiments, respectively. As illustrated in FIG. 6, the solar battery module 10y is different from the solar battery modules 10, 10x in that the colored layer 31 is formed only on a second wiring material 16y, but is not formed on the first wiring material 15y. In the second wiring material 16y, the colored layer 31 is formed only on the first surface of the core material 33 that faces the first protective member 12 side, but the colored layer 31 may be formed over the entire surface of the core material 33.

On the other hand, as illustrated in FIG. 7, in the solar battery module 10z, the colored layer 31 is formed only on a first wiring material 15z, but is not formed on a second wiring material 16z. In this case, a black sheet is provided above the second wiring material 16z, to thereby cover up the second wiring material 16z. Note that the colored layer 31 may be formed only in a range visible from the first protective member 12 side of the surface of the core material of each of the wiring materials.

In a solar battery module 10 illustrated in FIG. 8, cracks occur in some solar cells 11 after the string 23 is produced, for example. The solar battery module 10 includes a connection portion 40 in which the first wiring materials 15 are connected to each other, the connection portion 40 being formed when such a cell 11 is replaced with a new solar cell 11. To replace some solar cells 11 after the string 23 is produced, the first wiring materials 15 attached to a cell to be replaced and one of the cells adjacent to such a cell to be replaced are cut at two sites on the rear surface sides of the two cells. In FIG. 8, a solar cell 11n is the replaced cell, and a first wiring material 15s is a first wiring material which has been cut before the solar cell 11 is replaced with the solar cell 11n. The solar cell 11n is provided with a first wiring material 15n in advance, the first wiring material 15n being shorter than the other first wiring materials 15. The connection portion 40 is formed by joining the first wiring material 15s to the first wiring material 15n to overlap each other. The same configuration as the connection portion between the first wiring material 15a and the second wiring material 16 can be applied to the configuration of the connection portion 40.

Hereinafter, the colored layer 31 will be described in more detail.

As described above, the colored layer 31 absorbs at least 30% of visible light. The colored layer 31 absorbs at least 30% of the visible light having partial wavelengths, and preferably absorbs at least 30% of all wavelengths of the visible light, that is, at least 30% of the visible light having all wavelengths of 380 nm to 780 nm. In this case, the color of the colored layer 31 is black or blue black that is similar to the color of the solar cell 11, or is likely to be a color close to black or blue black. When the colored layer 31 is black in color, the visible light absorptivity of the colored layer 31 is preferably at least 50%, more preferably at least 60%, particularly preferably at 70%, and most preferably at least 80%.

The light absorptivity A (%) of the colored layer 31 can be calculated based on the following formula by measuring the light transmittance T (%) and the light reflectance R (%) of the colored layer 31 using a spectrophotometer that can measures the light having a wavelength range of interest.

$$A = 100 - T - R$$

The light transmittance and the light reflectance can be measured based on JIS-K7375. As the spectrophotometer, SolidSpec-3700 produced by SIMADZU CORPORATION can be used.

The colored layer 31 may be a metal layer or a layer in which a coloring material is dispersed inside the resin coating film, provided that the layer satisfies the conditions of the above-described visible light absorptivity. The colored layer 31 is typically formed on each of the core materials 30, 33 that are elongated bodies before being cut to individual sizes, but may be formed on each of the cut core materials 30, 33. The colored layer 31 consisting of the metal layer is formed by a plating method, for example. The plating method includes a black oxide coating method in which the surfaces of the core materials 30, 33 are subjected to oxidation processing. Note that each of the wiring materials may be a clad material formed by rolling and joining multiple metal layers including the colored layer 31, the base layer 32 and the like. Since the conductivity of the colored layer 31 consisting of the metal layer is typically high, electrical continuity can be provided by contact between the collector electrode 21 or 22 and the colored layer 31 or between the colored layers 31, for example.

Examples of types of plating layers (plating methods) that can be applied to the colored layer 31 include black zinc plating, black chromium plating, black nickel plating, black oxide coating, black alumite plating, black molybdenum plating, Raydent coating, chromate plating, nickel phosphorus plating, nickel boron plating, nickel teflon plating, zinc nickel plating, nickel chromium plating, aluminum nickel plating, zinc chromium plating, copper sulfate plating, copper pyrophosphate plating, copper cyanide plating, and the like. The color (hue, color tone) and visible light absorptivity of the plating layer can be adjusted by changing the plating treatment conditions.

The colored layer 31 may have a structure in which the coloring material is dispersed inside the resin coating film. In this case, the color and visible light absorptivity of the colored layer 31 can be adjusted by appropriately changing the type, the concentration, the layer thickness and the like of the coloring material. The resin forming the colored layer 31 is not limited to a particular resin, and is any resin forming the resin coating film and capable of retaining the coloring material, and may be a binder resin used for a paint. Since the colored layer 31 consisting of the resin layer containing the coloring material typically has a low conductivity or an insulator that does not have conductivity, while the conductivity varies depending on the coloring material, the collector electrodes 21, 22 preferably pierce the respective colored layers 31 to contact the base layer 32 or the respective core materials 30, 33, for example. The colored layer 31 consisting of the resin layer can be melted or decomposed by heat caused by soldering or the like, for example, to thereby remove a part of the colored layer 31 from the surfaces of the core materials 30, 33.

The colored layer 31 in which a coloring material is dispersed inside the resin coating film is formed by applying paint containing the coloring material such as a black pigment, for example. As a method of applying paint, brush coating, spray coating, inkjet printing, offset printing, stamp printing, screen printing, dip coating, electrodeposition coating, or the like can be applied. The colored layer 31 can be also formed after forming the string 23. The resin film containing the coloring material, or the like may be attached to the surfaces of the core materials 30, 33 to form the colored layers 31.

When the colored layer 31 is black in color, a black pigment such as carbon black, aniline black, titanium black, non-magnetic ferrite, or magnetite can be used as the coloring material. The color of the colored layer 31 may be adjusted to black or blue black by mixing a yellow pigment, a red pigment, a blue pigment and the like. When the coloring material is dispersed into the resin material, the content of the coloring material is about 5 vol% to 90 vol% with respect to the volume of the colored layer 31, for example. Furthermore, the coloring material may be directly attached to the wiring material without dispersing the coloring material into the resin material.

Note that the color of the colored layer 31 is not limited to black or blue black, and may be a color (for example, yellow, green, or red) that is different from the color of the solar cell 11 according to the design demanded in the market, for example. The colored layer 31 may have light absorptivity of at least 50% regarding the visible light having partial wavelengths. The color of the colored layer 31 is substantially black when the colored layer 31 absorbs at least 50% of visible light having a wide range of wavelengths of 380 nm to 780 nm as described above, but when the colored layer 31 has high light absorptivity within a specific range in the above-described wavelength range, and a portion of the visible light is reflected, the color of the colored layer 31 becomes yellow, green, red, or the like. To obtain the red colored layer 31, red pigment is used.

The colored layer 31 may transmit or reflect the light having a wavelength longer than the wavelength of visible light. The colored layer 31 transmits at least 30% of the light having wavelengths over the entire range from 780 nm to 1200 nm, for example, or transmits at least 70% of the light having partial wavelengths in the range from 780 nm to 1200 nm (hereinafter, referred to as near-infrared light). In the entire range of wavelengths from 780 nm to 1200 nm, the near-infrared light transmittance of the colored layer 31 is preferably at least 40%, more preferably at least 50%, and particularly preferably at least 60%.

A preferable example of the colored layer 31 is a colored layer having high visible light absorptivity and high near-infrared light transmittance. In this case, each wiring material has a similar color to the color of the solar cell 11, thereby enabling improvement ing the design properties of the solar battery module 10, and the near-infrared light that has passed through the colored layer 31 enters the solar cell 11, thereby enabling increase in the utilization efficiency of the light.

Examples of the preferable coloring materials (pigment) for improving the visible light absorptivity and near-infrared light transmittance of the colored layer 31 include anthraquinones, azos, anthrapyridones, perylenes, anthracenes, perinones, indanthrones, quinacridones, xanthenes, thioxanthenes, oxazines, oxazolines, indigoids, thioindigoids, quinophthalones, naphtalimides, cyanines, methines, pyrazolones, lactones, coumarins, bis-benzoxaxolylthiophenes, napthalenetetracarboxylic derivatives, phthalocyanines, triarylmethanes, aminoketones, bis (sthryl) biphenyls, azines, rhodamines, and derivatives thereof. The colored layers 31 may contain two or more types of coloring materials.

To obtain black or blue black colored layer 31 having high near-infrared light transmittance, a coloring material such as perylene black, bismuth sulfide, lumogen black, or silver-tin alloy particles is used.

As described above, providing the colored layer 31 that covers a surface on the side of the core material 30 or 33 forming each wiring material, the surface facing the first protective member 12 side enables each wiring material to be prevented from becoming conspicuous, thereby enabling improvement in the design properties of the solar battery module. In this case, the color of each wiring material is preferably black or blue black according to the colors of the solar cell 11 and the second protective member 13. The color of the entire solar battery panel can be made uniform, such as black or the like. Alternatively, the color of the colored layer 31 may be yellow, green, red, or the like according to the design demanded in the market.

Note that when the wiring materials each having the colored layer 31 are connected to each other, or when the wiring material having the colored layer 31 and the wiring material having no colored layer 31 are connected to each other, the connection may be determined based on the discoloration, deformation or the like of the colored layer 31. More specifically, when the connection portion and the non-connecting portion have different reflectance and roughness (for example, the reflectance changes by at least 20%, and the roughness changes by at least 10%), the connection can be determined based on these changes. When providing the colored layer 31 causes reduction in adhesion between the wiring material and the encapsulant layer, protrusions and recesses may be formed on a part of the colored layer 31, or the paint forming the colored layer 31 may be applied in a dotted shape, so that a portion where the adhesion is increased is provided. Alternatively, the core material or the base layer may be exposed by providing a slit on a part of the colored layer 31, thereby improving the adhesion between the wiring material and the encapsulant layer. A portion in which the adhesion with the encapsulant layer is increased may be formed at substantially constant intervals along the longitudinal direction of the wiring material, for example.

REFERENCE SIGNS LIST

| 10 | Solar battery module |
| 11 | Solar cell |
| 12 | First protective member |
| 13 | Second protective member |
| 14 | Encapsulant layer |
| 14a | First encapsulant layer |
| 14b | Second encapsulant layer |
| 15, 15a | First wiring material |
| 16 | Second wiring material |
| 17, 18 | Adhesive |
| 18a | Conductive filler |
| 20 | Photoelectric conversion part |
| 21, 22 | Collector electrode |
| 23 | String |
| 30, 33 | Core material |
| 31 | Colored layer |
| 32 | Base layer |
| 34, 38 | Protrusions and recesses |
| 35, 36 | Conductive member |
| 37 | Resin layer |
| 40 | Connection portion |

**Claims**

1. A solar battery module, comprising:

   multiple solar cells;
   a first protective member provided on a light receiving surface side of the multiple solar cells;
   a second protective member provided on a rear surface side of the multiple solar cells;
   a first wiring material for connecting adjacent solar cells; and
   a second wiring material for connecting strings, obtained by connecting the multiple solar cells via the first wiring materials, to each other,
   wherein at least one of the first wiring material and the second wiring material has a conductive core material, and a colored layer that covers a surface on a side of the core material that faces the first protective member, and
the colored layer absorbs at least 30% of visible light having wavelengths of 380 nm to 780 nm.

2. The solar battery module according to claim 1, wherein
the multiple solar cells each include a photoelectric conversion part, and collector electrodes provided on the photoelectric conversion part, and
the collector electrodes are connected to the first wiring material while penetrating the colored layer of the first wiring material.

3. The solar battery module according to claim 2, wherein
the first wiring material includes a base layer provided between the core material and the colored layer, and
the collector electrodes that have penetrated the colored layer of the first wiring material pierce into the base layer.

4. The solar battery module according to any one of claims 1 to 3, wherein
the colored layer transmits at least 30% of light having wavelengths over an entire range from 780 nm to 1200 nm, or transmits at least 70% of light having partial wavelengths in a range from 780 nm to 1200 nm.

5. The solar battery module according to any one of claims 1 to 4, wherein
the first wiring material and the second wiring material are connected through a conductive member which penetrates the colored layers.

6. The solar battery module according to any one of claims 1 to 5, wherein
the colored layer of at least one of the first wiring material and the second wiring material is formed on an entire surface except for both end surfaces in a longitudinal direction of the core material.

7. The solar battery module according to any one of claims 1 to 6, wherein
the colored layer of at least one of the first wiring material and the second wiring material is an insulator.

FIG. 1

EP 3 544 061 A1

30a    32    31    15

30c

30

30c

30b

FIG. 2A

30a, 34    32    31    15

30c

30

30c

30b

FIG. 2B

FIG. 3A

FIG. 3B

FIG. 3C

FIG. 4

FIG. 5A

FIG. 5B

FIG. 6

FIG. 7

FIG. 8

## INTERNATIONAL SEARCH REPORT

| International application No. |
|---|
| PCT/JP2017/044497 |

| A. CLASSIFICATION OF SUBJECT MATTER |
|---|
| Int.Cl. H01L31/05(2014.01)i |
| According to International Patent Classification (IPC) or to both national classification and IPC |

| B. FIELDS SEARCHED |
|---|
| Minimum documentation searched (classification system followed by classification symbols) |
| Int.Cl. H01L31/05 |

| Documentation searched other than minimum documentation to the extent that such documents are included in the fields searched | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

| Electronic data base consulted during the international search (name of data base and, where practicable, search terms used) |
|---|
| |

### C. DOCUMENTS CONSIDERED TO BE RELEVANT

| Category* | Citation of document, with indication, where appropriate, of the relevant passages | Relevant to claim No. |
|---|---|---|
| Y | JP 2014-042065 A (HITACHI METALS, LTD.) 06 March 2014, entire text, fig. 1, 4 (Family: none) | 1-7 |
| Y | JP 2015-185712 A (PANASONIC IP MANAGEMENT CO., LTD.) 22 October 2015, paragraphs [0027]-[0035] (Family: none) | 1-7 |
| Y | WO 2015/008610 A1 (SANYO ELECTRIC CO., LTD.) 22 January 2015, paragraphs [0013]-[0019], fig. 1-2 & US 2016/0126387 A1, paragraphs [0020]-[0026], fig. 1-2 | 1-7 |
| Y | JP 2009-302327 A (SHARP CORP.) 24 December 2009, paragraphs [0026]-[0050], fig. 1-22 (Family: none) | 5-7 |
| A | | 1-4 |
| A | JP 2009-206493 A (SANYO ELECTRIC CO., LTD.) 10 September 2009, paragraphs [0048]-[0051], fig. 8-9 & US 2009/0194144 A1, paragraphs [0074]-[0077], fig. 8-9 & EP 2086022 A1 & CN 101499494 A | 1-7 |

☒ Further documents are listed in the continuation of Box C.  ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 01 February 2018 (01.02.2018) | 13 February 2018 (13.02.2018) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
| --- |
| PCT/JP2017/044497 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | US 2014/0246068 A1 (ROBERT BOSCH GMBH) 04 September 2014, paragraph [0029], fig. 2-3 & DE 102013203638 A1 & CN 104037241 A | 1-7 |
| A | JP 2004-247402 A (SANYO ELECTRIC CO., LTD.) 02 September 2004, paragraph [0107] (Family: none) | 1-7 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016143680 A